# EUROPEAN PATENT APPLICATION

(11) **EP 4 748 650 A1**
(43) Date of publication of application: **27.05.2026**
(21) Application number: 25846642.4
(22) Date of filing: 21.05.2025
(51) Int. Cl.: B60R 7/00

(54) **ELECTRONIC DEVICE MOUNTING APPARATUS AND ELECTRONIC DEVICE**

(30) Priority: 31.07.2024 CN 202411047815
(71) Applicant: HUAWEI TECHNOLOGIES CO., LTD., Shenzhen 518129 (CN)
(72) Inventor: LI, Zhi, Shenzhen, Guangdong 518129 (CN); MAO, Yajie, Shenzhen, Guangdong 518129 (CN); WANG, Zhenyu, Shenzhen, Guangdong 518129 (CN); MA, Liang, Shenzhen, Guangdong 518129 (CN); LI, Yunchao, Shenzhen, Guangdong 518129 (CN)
(74) Representative: Körber, Martin Hans
(86) International application number: PCT/CN2025/096218
(87) International publication number: WO 2026/026150

(57) **Abstract**

Disclosed is an electronic device mounting apparatus, including a first body, a second body, and an anti-slip member. The first body includes a first magnetic member, and a mounting structure for mounting of an electronic device is disposed on the first body. The second body includes a second magnetic member, the second magnetic member is configured to cooperate with the first magnetic member to generate mutually attractive forces, and the second magnetic member and the first magnetic member are respectively absorbed on two sides of a support apparatus by the mutually attractive forces. The anti-slip member is connected to a surface that is of the first body and that is on a side facing the second body. For the electronic device mounting apparatus provided in the embodiment of this application, there is no need to rely on a pole near a house or a double-sided tape, and operations such as drilling holes in a wall or a wooden board by using a dedicated tool are also not required. The first body and the second body can be fastened on the support apparatus, for example, glass, through magnetic attraction, and mounting can be completed by a user through manual operations. This ensures mounting reliability while facilitating mounting. In addition, the anti-slip member is disposed on the first body, so that it can be ensured that an absorption position remains fixed or basically fixed after the first body is absorbed on the glass, thereby ensuring stability of mounting the electronic device.

## Description

This application claims priority to Chinese Patent Application No. 202411047815.5, filed with the China National Intellectual Property Administration on July 31, 2024 and entitled "ELECTRONIC DEVICE MOUNTING APPARATUS AND ELECTRONIC DEVICE", which is incorporated herein by reference in its entirety.

### TECHNICAL FIELD

This application relates to the field of communication technologies, and specifically, to an electronic device mounting apparatus and an electronic device.

### BACKGROUND

With the continuous development of outdoor communication devices, customers have higher requirements on mounting and use of the outdoor communication devices, which are continuously developing toward low-cost mounting and operation and maintenance, userperformed mounting, and optimal user experience. Currently, the outdoor communication devices have problems such as difficult mounting, unreliable mounting, and overly technical operation. For example, the outdoor communication device may be fastened to a pole through a hose clamp. This requires presence of a pole near a user's home, making it difficult to meet requirements of most homes. For another example, the outdoor communication device may be mounted on a wall through wall nails. This may cause permanent damage to the wall, and requires a professional person for mounting. For still another example, the outdoor communication device may be pasted and fastened on glass through a double-sided tape. However, the double-sided tape has a high requirement on a temperature and an activation pressure. If an ambient temperature is low or the activation pressure is excessively small, the double-sided tape cannot achieve effective bonding, which easily causes the outdoor communication device to fall off.

### SUMMARY

In view of this, this application provides an electronic device mounting apparatus and an electronic device, to resolve the foregoing problems of difficult mounting, unreliable mounting, and overly technical operation of the foregoing existing outdoor communication device.

According to a first aspect, this application provides an electronic device mounting apparatus, which includes a first body, a second body, and an anti-slip member. The first body includes a first magnetic member, and a mounting structure for mounting of an electronic device is disposed on the first body. The second body includes a second magnetic member, the second magnetic member is configured to cooperate with the first magnetic member to generate mutually attractive forces, and the second magnetic member and the first magnetic member are respectively absorbed on two sides of a support apparatus by the mutually attractive forces. The anti-slip member is connected to a surface that is of the first body and that is on a side facing the second body.

The electronic device mounting apparatus provided in the embodiment of this application may be fastened on glass of a window through magnetic attraction without relying on a pole near a house. Because most houses have glass of windows, the mounting apparatus provided in the embodiment can meet requirements of most users. Certainly, the mounting apparatus may alternatively be fastened on another support apparatus with a small thickness, and application scenarios are more diversified. In addition, the mounting apparatus is detachably clamped on the two sides of the support apparatus, for example, glass, through magnetic attraction, to facilitate assembly and disassembly operations. Mounting can be completed by the user through manual operations without operations such as drilling holes in a wall or a wooden board by using a dedicated tool. Furthermore, the mounting apparatus does not need to be pasted on the glass by using a double-sided tape, and is not affected either by an ambient temperature through magnetic attraction. Moreover, the user also does not need to apply a pressure, and the first body and the second body can be fastened on the support apparatus, for example, glass, by a magnetic attraction force between the first body and the second body. This ensures mounting reliability while facilitating mounting. In addition, the anti-slip member is disposed on the first body, so that it can be ensured that an absorption position remains fixed or basically fixed after the first body is absorbed on the glass, thereby ensuring stability of mounting the electronic device.

In a possible implementation, the first body further includes a first casing, and the first casing is wrapped around a surface of the first magnetic member; and/or the second body further includes a second casing, and the second casing is wrapped around a surface of the second magnetic member. The first casing may be completely wrapped around the first magnetic member, so that the first magnetic member can be protected, to prevent the first magnetic member from being exposed by sunlight or eroded by rain. This helps prolong an overall service life of the first body.

In a possible implementation, the first casing includes a first housing and a first cover body, the first cover body is engaged with the first housing, a first enclosed space is formed between the first cover body and the first housing, and the first magnetic member is disposed in the first enclosed space; and/or the second casing includes a second housing and a second cover body, the second cover body is engaged with the second housing, a second enclosed space is formed between the second cover body and the second housing, and the second magnetic member is disposed in the second enclosed space. In the first casing, the first housing and the first cover body are separately assembled, so that assembly of the first casing and the first magnetic member can be facilitated.

**In** a possible implementation, the first housing and the first cover body each are provided with a first positioning groove, and when the first housing and the first cover body are engaged with each other, the first positioning groove of the first housing and the first positioning groove of the first cover body are correspondingly engaged with each other, to form the first enclosed space between the first positioning groove of the first housing and the first positioning groove of the first cover body; and/or the second housing and the second cover body each are provided with a second positioning groove, and when the second housing and the second cover body are engaged with each other, the second positioning groove of the second housing and the second positioning groove of the second cover body are correspondingly engaged with each other, to form the second enclosed space between the second positioning groove of the second housing and the second positioning groove of the second cover body.

A form of cooperation between the first housing and the first cover body is used as an example. A plurality of first positioning grooves in the first housing and a plurality of first positioning grooves in the first cover body may be provided. In this case, there may be a plurality of first enclosed spaces formed by the first positioning grooves in the first housing and the first positioning grooves in the first cover body. The first magnetic members may be disposed in all of the first enclosed spaces, or the first magnetic members may be disposed in a part of the first enclosed spaces, and the first magnetic members may be flexibly disposed in the first enclosed spaces at different positions, to meet different mounting scenarios of the electronic device. In addition, an assembly manner of the second magnetic member, the second cover body, and the second housing may be the same as an assembly manner of the first cover body, the first housing, and the first magnetic member 11, and corresponding technical effects are also similar. Details are not described herein again.

In a possible implementation, the first housing and the first cover body are sealingly engaged with each other; and/or the second housing and the second cover body are sealingly engaged with each other; and/or the first positioning groove of the first housing and the first positioning groove of the first cover body are sealingly engaged with each other; and/or the second positioning groove of the second housing and the second positioning groove of the second cover body are sealingly engaged with each other. Therefore, in a sealingly engaged manner, contaminants such as water vapor can be prevented from penetrating into the inside of the first housing and the first cover body and eroding the first magnetic member, or from penetrating into the inside of the second housing and the second cover body and eroding the second magnetic member.

In a possible implementation, the first housing and the first cover body are sealingly engaged with each other by using a glue dispensing process, a melting process, or a waterproof structure; and/or the second housing and the second cover body are sealingly engaged with each other by using a glue dispensing process, a melting process, or a waterproof structure; and/or the first positioning groove of the first housing and the first positioning groove of the first cover body are sealingly engaged with each other by using a glue dispensing process, a melting process, or a waterproof structure; and/or the second positioning groove of the second housing and the second positioning groove of the second cover body are sealingly engaged with each other by using a glue dispensing process, a melting process, or a waterproof structure. In the foregoing sealing manner, effective sealing can be ensured, and contaminants such as water vapor can be prevented from eroding the magnetic member.

In a possible implementation, the first casing is wrapped around the surface of the first magnetic member by using an injection molding process; and/or the second casing is wrapped around the surface of the second magnetic member by using an injection molding process. The first casing or the second casing formed through injection molding may implement an integrated structure design. This helps improve structural reliability of the first casing and the second casing, and can also ensure that a better sealing effect is generated for the first magnetic member or the second magnetic member.

In a possible implementation, the mounting structure includes a fastener. One end of the fastener is connected to the first body, and the other end of the fastener protrudes from a surface of the first body for mounting of the electronic device. The fastener may be a screw, a pin, a plastic member, or the like. The fastener has stable structural support strength, can ensure reliable support for the electronic device, and also facilitates mounting of the electronic device.

In a possible implementation, the fastener includes a connection portion and a limiting portion. One end of the connection portion is connected to the first body, and an end that is of the connection portion and that is away from the first body is connected to the limiting portion. The limiting portion protrudes from a side surface of the connection portion in a radial direction of the connection portion. A groove-shaped structure may be formed between the limiting portion, the connection portion, and the first body. At least a part of a side wall of a clamping groove of the electronic device may be located in the groove-shaped structure, and can be engaged with the connection portion. In addition, the side wall of the clamping groove can be limited in a thickness direction of the first body through the limiting portion, to prevent the electronic device from falling off.

In a possible implementation, the electronic device mounting apparatus further includes a support assembly. The support assembly is connected to the first body and/or the second body, and is switchable between a supporting state and a stored state. When the support assembly is in the supporting state, at least a part of the support assembly protrudes from a surface of the second body. Through blocking of the support assembly, the first body and the second body are not attached to each other, so that the first body and the second body can be prevented from being difficult to separate after being absorbed and attached, or the user can be prevented from being pinched.

In a possible implementation, when the first body and/or the second body are/is attached to the support apparatus to cause the support assembly to be in the stored state, the support assembly is stored in the second body, and the support assembly does not protrude from the surface of the first body and/or the surface of the second body, so that it can be ensured that the first body and/or the second body can be effectively attached to the support apparatus, for example, glass, when the first body and/or the second body are/is in use.

In a possible implementation, a position corresponding to the support assembly in the stored state is a first position, a position corresponding to the support assembly in the supporting state is a second position, and an angle between the first position and the second position is greater than 90°. When the support assembly is switched from the supporting state to the stored state, the first body and/or the second body on which the support assembly is disposed are/is enabled to move in a direction away from the first position and in a direction close to the support apparatus. When the first body and/or the second body on which the support assembly is disposed are/is attached to the support apparatus, the support assembly is switched to the stored state.

In a possible implementation, the support assembly includes a support member, an elastic member, and a rotating shaft, and the support member is rotatably connected to the first body and/or the second body through the rotating shaft. One end of the elastic member is connected to the first body and/or the second body, and the other end of the elastic member is connected to the support member. In the supporting state, at least a part of the support member protrudes from the surface of the first body and/or the surface of the second body by an elastic force of the elastic member. For example, the support assembly is disposed on the second body. When the second body is not in use, the support assembly is in the supporting state, and in the supporting state, the elastic member may keep in a compressed state. In this case, an elastic force generated by the elastic member may allow at least a part of the support member to keep in the supporting state, that is, protruding from the surface of the second body, and to be located between the first body and the second body.

In a possible implementation, an angle by which the support member rotates when the stored state is switched to the supporting state is greater than 90°. For ease of description, a position of the support member in the stored state may be defined as a first position, and a position of the support member in the supporting state may be defined as a second position. An angle by which the support member rotates when being switched from the first position to the second position is greater than 90°. In this case, when the support member at the second position is subject to a squeezing force from the first body in a thickness direction of the second body, the support member may generate a component force in a direction away from the first position, and the component force does not cause the support member to rotate to the first position, so that it can be ensured that the support member can stably function as support.

In a possible implementation, the first body and/or the second body are/is provided with a mounting groove, the rotating shaft is connected to an inner wall of the mounting groove, and in the stored state, the support member is stored in the mounting groove. In the stored state, the support member is stored in the mounting groove, so that the support member does not protrude from the surface of the first body and/or the surface of the second body, so that it can be ensured that the first body and/or the second body can be effectively attached to the support apparatus, for example, glass.

In a possible implementation, the anti-slip member and the first casing of the first body are integrally formed by using a molding process. The anti-slip member and the first casing may be reliably combined and fastened by using a molding process, so that the anti-slip member can be effectively prevented from falling off.

In a possible implementation, the electronic device mounting apparatus further includes a buffer member. The buffer member is connected to the first body, and at least a part of the buffer member protrudes from the surface of the first body. In a process in which the electronic device is mounted on the mounting structure of the first body, the buffer member may implement buffering through contact with the electronic device, so that the electronic device is prevented from directly colliding with or squeezing the first body, and a direct impact force of the electronic device on the first body is reduced. In addition, in a process in which the electronic device is mounted on the first body, when the electronic device is in contact with the buffer member, the buffer member may provide a specific damping force, so that a mounting feel and user experience can be improved.

In a possible implementation, the first body is provided with a groove, and at least a part of the buffer member is disposed in the groove. The part that is of the buffer member and that is located in the groove may be bonded to an inner wall of the groove by using an adhesive, so that the buffer member can be reliably fastened, and prevented from falling off.

In a possible implementation, the buffer member and the mounting structure are both disposed on a surface that is of the first body and that faces away from the second body, so that a better buffer effect can be achieved in the process in which the electronic device is mounted on the mounting structure.

In a possible implementation, the electronic device mounting apparatus further includes a tension member, and one end of the tension member is connected to the first body or the second body. An end that is of the tension member and that is away from the first body or the second body is a free end, and the free end may be connected to a nearby fixed structure. For example, when the first body and the second body are clamped on two sides of the glass of the window, the free end of the tension member may be bound to a handle of the window, or bound to an appropriate structure, for example, a window frame. In this way, when the first body or the second body pulled by the tension member is accidentally detached from the glass, under the action of the tension member, the pulled first body or second body can still be prevented from falling off to the ground and being damaged.

In a possible implementation, the first body or the second body is provided with a mounting hole. A latch is disposed on an end of the tension member, and at least a part of the latch passes through the mounting hole. The tension member may be locked onto a side wall of the mounting hole through the latch, thereby helping assembly of the tension member and the first body.

In a possible implementation, the first body is provided with a limiting hole, and the limiting hole is configured to cooperate with a limiting protrusion on the electronic device. In a process of mounting the electronic device, the limiting protrusion on the electronic device may be inserted into the limiting hole of the first body, so that the electronic device can be mounted and limited, and the electronic device can also be prevented from shaking after being mounted, thereby ensuring mounting stability of the electronic device.

In a possible implementation, the electronic device includes a camera, a lamp, or an electronic clock.

In a possible implementation, the electronic device includes a communication device, and the communication device includes customer premises equipment, a remote radio unit, an interface data unit, or a router.

According to a second aspect, an embodiment of this application further provides an electronic device, including a body and the electronic device mounting apparatus provided in the first aspect of this application. The electronic device mounting apparatus is used for mounting of the body.

It should be understood that the foregoing general descriptions and the following detailed descriptions are merely examples, and are not intended to limit this application.

### BRIEF DESCRIPTION OF DRAWINGS

To describe the technical solutions in embodiments of this application more clearly, the following briefly describes accompanying drawings for describing embodiments. It is clear that the accompanying drawings in the following descriptions show merely some embodiments of this application, and a person of ordinary skill in the art may derive other drawings from these accompanying drawings without creative efforts.
FIG. 1 is a diagram of a structure of an electronic device according to an embodiment of this application;
FIG. 2 is a diagram of a structure of a first body in an electronic device mounting apparatus according to an embodiment of this application;
FIG. 3 is a sectional view along A-A in FIG. 2;
FIG. 4 is a diagram of a structure of a first body in an electronic device mounting apparatus according to another embodiment of this application;
FIG. 5 is a diagram of a structure of an electronic device according to another embodiment of this application;
FIG. 6 is a partial side view of a first body in an electronic device mounting apparatus according to an embodiment of this application;
FIG. 7 is a partial sectional view of a first body in an electronic device mounting apparatus and an electronic device that are connected according to an embodiment of this application;
FIG. 8 is a diagram of a structure of a second body in an electronic device mounting apparatus according to an embodiment of this application;
FIG. 9 is a sectional view along B-B in FIG. 8;
FIG. 10 is a diagram showing a state in which an electronic device mounting apparatus is in use according to an embodiment of this application;
FIG. 11 is a diagram showing a state in which an electronic device mounting apparatus and an electronic device are assembled according to an embodiment of this application;
FIG. 12 is an exploded view of assembling a first body and an anti-slip member in an electronic device mounting apparatus according to an embodiment of this application;
FIG. 13 is a front view of a first body in an electronic device mounting apparatus according to an embodiment of this application;
FIG. 14 is a front view of a second body in an electronic device mounting apparatus according to an embodiment of this application;
FIG. 15 is an exploded view of a first body in an electronic device mounting apparatus according to an embodiment of this application;
FIG. 16 is an exploded view of a first body in an electronic device mounting apparatus according to another embodiment of this application;
FIG. 17 is an exploded view of a second body in an electronic device mounting apparatus according to an embodiment of this application;
FIG. 18 is an exploded view of a second body in an electronic device mounting apparatus according to another embodiment of this application;
FIG. 19 is a diagram of a structure of a second body in an electronic device mounting apparatus according to another embodiment of this application;
FIG. 20 is a diagram of cooperation between a first body and a second body when a support assembly in an electronic device mounting apparatus is in a supporting state according to an embodiment of this application;
FIG. 21 is a diagram of a structure of a second body in an electronic device mounting apparatus according to another embodiment of this application;
FIG. 22 is an exploded view of a support assembly in an electronic device mounting apparatus according to an embodiment of this application;
FIG. 23 is a diagram of a process in which a second body in an electronic device mounting apparatus is mounted on glass according to an embodiment of this application;
FIG. 24 is a diagram showing a state in which a second body in an electronic device mounting apparatus is attached to glass according to an embodiment of this application;
FIG. 25 is a side view of a second body in an electronic device mounting apparatus according to an embodiment of this application;
FIG. 26 is a partially enlarged diagram at a position C in FIG. 22;
FIG. 27 is a diagram of a structure of a first body in an electronic device mounting apparatus according to another embodiment of this application;
FIG. 28 is a diagram of a structure of an electronic device according to another embodiment of this application;
FIG. 29 is a diagram of cooperation between a first body and a tension member in an electronic device mounting apparatus according to an embodiment of this application; and
FIG. 30 is a diagram in which a first body and a second body in an electronic device mounting apparatus separately cooperate with a tension member according to an embodiment of this application.

Reference numerals:
1: first body;
   11: first magnetic member;
   12: first casing;
      121: first housing;
      122: first cover body;
   12a: first positioning groove;
   12b: first positioning groove;
   13: first mounting surface;
   14: limiting hole;
2: second body;
   21: second magnetic member;
   22: second casing;
      221: second housing;
      222: second cover body;
   22a: second positioning groove;
   22b: second positioning groove;
   23: second mounting surface;
   24: mounting groove;
      241: inner wall;
3: mounting structure;
   31: fastener;
   311: connection portion;
   312: limiting portion;
4: support assembly;
   41: support member;
   42: elastic member;
      421: elastic arm;
   43: rotating shaft;
5: anti-slip member;
6: buffer member;
7: tension member;
   71: free end;
   72: latch;
8: mounting hole;
100: electronic device;
   110: clamping groove;
      111: side wall;
   120: limiting protrusion;
200: glass;
Z: thickness direction;
M1: first position;
M2: second position.

### DESCRIPTION OF EMBODIMENTS

To better understand technical solutions of this application, the following describes embodiments of this application in detail with reference to accompanying drawings.

It should be noted that the described embodiments are merely a part rather than all of embodiments of this application. All other embodiments obtained by a person of ordinary skill in the art based on embodiments of this application without creative efforts shall fall within the protection scope of this application.

Terms used in embodiments of this application are merely for the purpose of describing specific embodiments, and are not intended to limit this application. The terms "a", "the", and "this" of singular forms used in embodiments and the appended claims of this application are also intended to include plural forms, unless otherwise specified in the context clearly.

It should be understood that the term "and/or" used in this specification describes only an association relationship between associated objects and indicates that three relationships may exist. For example, A and/or B may indicate the following three cases: Only A exists, both A and B exist, and only B exists. In addition, the character "/" in this specification generally indicates an "or" relationship between associated objects.

In descriptions of this application, unless otherwise specified and limited, the terms "first" and "second" are merely intended for a purpose of description, and shall not be understood as an indication or implication of relative importance. Unless otherwise specified or stated, the term "a plurality of" means two or more. The terms "connect", "fasten", and the like all should be understood in a broad sense. For example, "connect" may be a fastened connection, a detachable connection, an integrated connection, or an electrical connection, or may be a direct connection or an indirect connection through an intermediate medium. A person of ordinary skill in the art may understand specific meanings of the foregoing terms in this application based on specific situations.

An outdoor communication device is a device that can implement signal transmission/reception. For example, the outdoor communication device can convert a signal or a wired broadband signal provided by an operator into a broadband signal or a Wi-Fi signal that is directly used by a user. The outdoor communication device may be customer premise equipment (Customer Premise Equipment, CPE), a base station, or the like, and may be widely used for network access in various scenarios such as a home, a hospital, a factory, a community, an airport, and a railway station.

The outdoor communication device needs to be reliably mounted before use. In a related technology, the outdoor communication device may be mounted on a pole through cooperation between a hose clamp and a dedicated base. The hose clamp needs to be fastened to the dedicated base, then the hose clamp needs to be wrapped around and bound to the pole, and finally the outdoor communication device can be mounted on the dedicated base. However, such a mounting manner is technical and has poor operability, and a pole that can be used for mounting of a hose clamp is required near a user's house, making it difficult to meet use requirements of most users.

In addition, a mounting manner in which the outdoor communication device is mounted on a wall may be used. Specifically, a hole may be drilled on the wall by using a drilling tool, for example, an electric screwdriver, then a dedicated base may be fastened on the wall by using a bolt, and finally the outdoor communication device can be mounted on the dedicated base. However, such a mounting manner requires a professional engineering person for on-site mounting, which results in high mounting costs and great difficulty. In addition, drilling holes causes permanent damage to the wall, which is unacceptable to some users.

For another example, alternatively, the outdoor communication device may be pasted on glass of a window by using a double-sided tape. The double-sided tape is generally a pressure-sensitive adhesive. Due to a material characteristic of the pressure-sensitive adhesive, the pressure-sensitive adhesive cannot achieve a normal bonding function in a low-temperature environment below 20°C. In addition, activation of the pressure-sensitive adhesive has a specific pressure requirement, for example, a pressure generally needs to be greater than 0.1 MPa. If the pressure is small, it is difficult to ensure reliable bonding of the outdoor communication device, which easily causes the device to fall off.

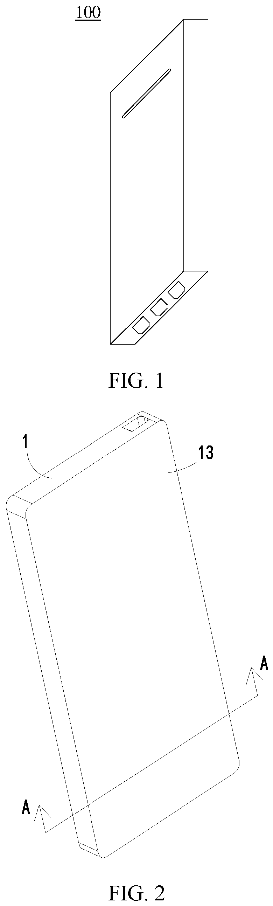

In view of this, an embodiment of this application provide an electronic device mounting apparatus (briefly referred to as a mounting apparatus below). The mounting apparatus may implement mounting of an electronic device according to a magnetic attraction principle. FIG. 1 is a diagram of a structure of an electronic device according to an embodiment of this application. Refer to FIG. 1. The electronic device may be a device that can be mounted on the mounting apparatus provided in the embodiment, for example, a camera, a lamp, or an electronic clock. The electronic device may alternatively be a communication device. For example, the communication device may be customer premise equipment (Customer Premise Equipment, CPE), a remote radio unit (Remote Radio Unit, RRU), an interface data unit (Interface Data Unit, IDU), or a router. A type of the communication device, namely, the electronic device 100 is not limited in embodiments. In addition, the mounting apparatus provided in the embodiment may also be used for mounting of a mechanical device, for example, a mechanical clock. This is not limited in embodiments.

In an embodiment, the mounting apparatus provided in the embodiment may be packaged and sold independently of the electronic device. In some other embodiments, the electronic device may include a body and the mounting apparatus provided in the embodiment. The body may achieve functions of the electronic device, such as wireless communication, lighting, and camera shooting, and the mounting apparatus may implement mounting of the body. The body and the mounting apparatus may be packaged and sold together as a whole.

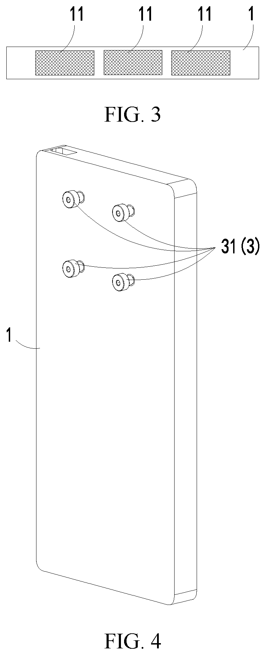

FIG. 2 is a diagram of a structure of a first body in an electronic device mounting apparatus according to an embodiment of this application. Refer to FIG. 2. The mounting apparatus provided in this embodiment includes a first body 1. The first body 1 includes a first mounting surface 13 that is configured to be attached to a support apparatus. The support apparatus may be a glass or resin product with a small thickness or the like. FIG. 3 is a sectional view along A-A in FIG. 2. As shown in FIG. 3, the first body 1 includes a first magnetic member 11. The first magnetic member 11 may be a magnet that can generate a magnetic force, and a material of the first magnetic member 11 may be a permanent magnetic material, for example, neodymium iron boron, samarium cobalt, neodymium nickel cobalt, or ferrite. FIG. 4 is a diagram of a structure of a first body 1 in an electronic device mounting apparatus according to another embodiment of this application. Refer to FIG. 4. A mounting structure 3 may be disposed on the first body 1. The mounting structure 3 may be used for mounting of an electronic device, and can reliably support and fasten the electronic device.

In an embodiment, with reference to FIG. 4, the mounting structure 3 may include a fastener 31. One end of the fastener 31 is connected to the first body 1, and the other end of the fastener 31 protrudes from a surface of the first body 1. The fastener 31 may be a screw, a pin, a plastic member, or the like. The fastener 31 has stable structural support strength, can ensure reliable support for the electronic device, and also facilitates mounting of the electronic device. In an embodiment, the mounting structure 3 may include one fastener 31, or may include a plurality of fasteners 31. Refer to FIG. 4. When the mounting structure 3 includes the plurality of fasteners 31, mounting reliability of the electronic device can be ensured.

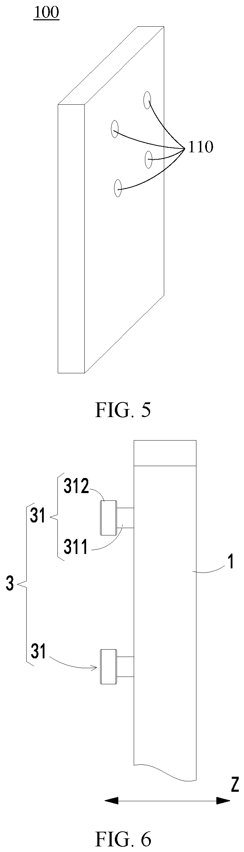

FIG. 5 is a diagram of a structure of an electronic device according to another embodiment of this application. Refer to FIG. 5. The electronic device 100 may have a clamping groove 110. Positions and a quantity of clamping grooves 110 may be both consistent with positions and a quantity of fasteners 31. The electronic device 100 may be hung on a corresponding fastener 31 through a clamping groove 110. This facilitates mounting of the electronic device 100.

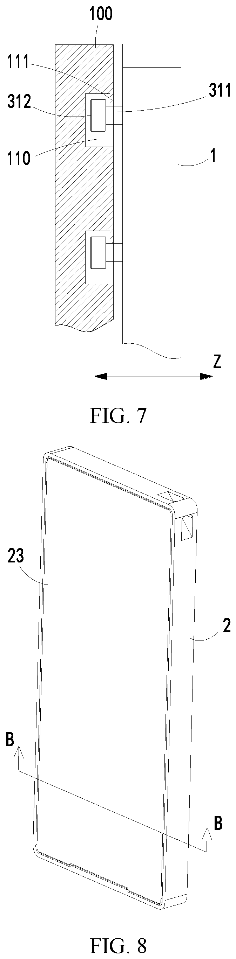

In an embodiment, FIG. 6 is a partial side view of a first body 1 in an electronic device mounting apparatus according to an embodiment of this application. Refer to FIG. 6. The fastener 31 may include a connection portion 311 and a limiting portion 312. One end of the connection portion 311 is connected to the first body 1, and an end that is of the connection portion 311 and that is away from the first body 1 is connected to the limiting portion 312. The limiting portion 312 protrudes from a side surface of the connection portion 311 in a radial direction of the connection portion 311. The radial direction of the connection portion 311 is a direction perpendicular to a thickness direction Z of the first body 1. FIG. 7 is a partial sectional view of a first body 1 in an electronic device mounting apparatus and an electronic device that are connected according to an embodiment of this application. As shown in FIG. 7, in this embodiment, a groove-shaped structure may be formed between the limiting portion 312, the connection portion 311, and the first body 1. At least a part of a side wall 111 of the clamping groove 110 of the electronic device 100 may be located in the groove-shaped structure, and can be engaged with the connection portion 311. In addition, the side wall 111 of the clamping groove 110 can be limited in the thickness direction Z of the first body 1 through the limiting portion 312, to prevent the electronic device 100 from falling off.

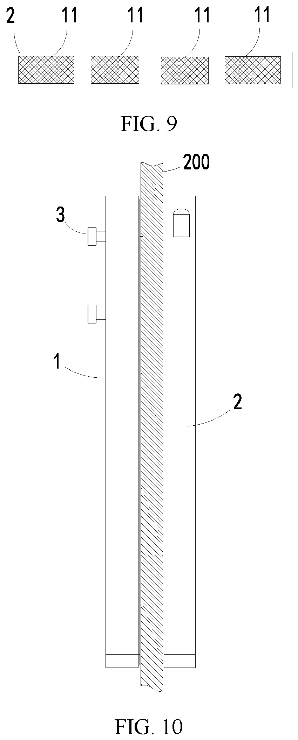

FIG. 8 is a diagram of a structure of a second body 2 in an electronic device mounting apparatus according to an embodiment of this application. Refer to FIG. 8. The second body 2 includes a second mounting surface 23 that is configured to be attached to the foregoing support apparatus, for example, glass. FIG. 9 is a sectional view along B-B in FIG. 8. As shown in FIG. 9, the mounting apparatus further includes the second body 2, and the second body 2 includes a second magnetic member 21. The second magnetic member 21 may also be a magnet that can generate a magnetic force, and a material of the second magnetic member 21 may also be a permanent magnetic material, for example, neodymium iron boron, samarium cobalt, neodymium nickel cobalt, or ferrite. The second magnetic member 21 is configured to cooperate with the first magnetic member 11 to generate mutually attractive forces. For example, polarities of the first magnetic member 11 and the second magnetic member 21 are opposite. In this case, according to a principle of attraction between opposite polarities, the first body 1 and the second body 2 may be driven, by a magnetic attraction force, to generate a trend of moving toward each other.

In some embodiments, one of the first body 1 and the second body 2 includes a magnetic member that can generate a magnetic force, and the other of the first body 1 and the second body 2 may include a metal magnetic conductive member. The metal magnetic conductive member may include iron, nickel, a silicon steel plate, a nickel-iron alloy, a ferrite material, and the like. The metal magnetic conductive member cannot generate a magnetic force, but can be absorbed by the magnetic member. Therefore, mutually attractive forces may also be generated between the magnetic member and the metal magnetic conductive member.

FIG. 10 is a diagram showing a state in which an electronic device mounting apparatus is in use according to an embodiment of this application. Refer to FIG. 10. During use of the mounting apparatus provided in the embodiment, the first body 1 and the second body 2 may be respectively disposed on two sides of the foregoing support apparatus, for example, glass. The support apparatus may be glass 200 with a small thickness shown in FIG. 10, or may be another product made of a material, for example, resin, with a small thickness. The support apparatus may allow a magnetic field to pass through. To be specific, sufficient mutually attractive magnetic attraction forces can be generated between the first magnetic member 11 and the second magnetic member 21 that are located on the two sides of the support apparatus, to ensure that the first body 1 and the second body 2 can be clamped on two surfaces of the support apparatus.

One or more first magnetic members 11 and one or more than two second magnetic members 21 may be disposed. Quantities, sizes, and distribution of the first magnetic members 11 and the second magnetic members 21 may all be dynamically adjusted. For example, a plurality of first magnetic members 11 may be disposed, and the plurality of first magnetic members 11 may be disposed at a position that is of the first body 1 and that is close to an edge of the first body 1 and may be disposed at a position in the middle of the first body 1. The quantity, the size, and the distribution of the second magnetic members 21 may all be the same as those of the first magnetic members 11, so that each region position of the first body 1 and the second body 2 can be reliably absorbed on the support apparatus, for example, glass, by a magnetic attraction force.

In some other embodiments, the quantities, the sizes, and the distribution of the first magnetic members 11 and the second magnetic members 21 may be flexibly adjusted based on different mounting environments. For example, the quantities, the sizes, and the distribution of the first magnetic members 11 and the second magnetic members 21 may be determined based on factors such as a material, a thickness, and a magnetic attraction force requirement of the support apparatus, for example, glass. This is not limited in embodiments.

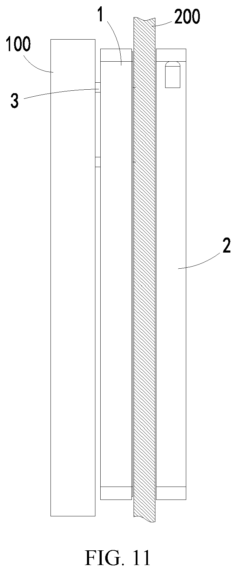

For example, with reference to FIG. 10, an example in which the support apparatus is glass 200 of a window is used for description. During mounting, the first body 1 may be first positioned on a side of the glass 200, so that the first mounting surface 13 of the first body 1 is attached to a surface of the glass 200. The first body 1 may be kept positioned at a mounting position by manually holding the first body 1. Then, the second mounting surface 23 of the second body 2 may be attached to a surface that is of the glass 200 and that is on a side facing away from the first body 1, and a position of the second body 2 is aligned with that of the first body 1, so that the first body 1 and the second body 2 can be stably fastened on the two sides of the glass 200 by the magnetic attraction force between the first magnetic member 11 and the second magnetic member 21. FIG. 11 is a diagram showing a state in which an electronic device mounting apparatus and an electronic device are assembled according to an embodiment of this application. Refer to FIG. 11. Finally, the electronic device 100 may be mounted on the mounting structure 3 of the first body 1, so that the electronic device 100 is mounted.

When the electronic device is an outdoor electronic device, the first body 1 may be disposed on a side that is of the glass 200 of the window and that faces the outdoors, and the second body 2 is disposed on an inner side that is of the glass 200 of the window and that faces the indoors. When the electronic device is an indoor electronic device, the first body 1 may be disposed on a side that is of the glass 200 of the window and that faces the indoors, and the second body 2 may be disposed on a side that is of the glass 200 of the window and that faces the outdoors. Therefore, the first body 1 and the second body 2 may be flexibly disposed indoors or outdoors according to a mounting requirement for the electronic device.

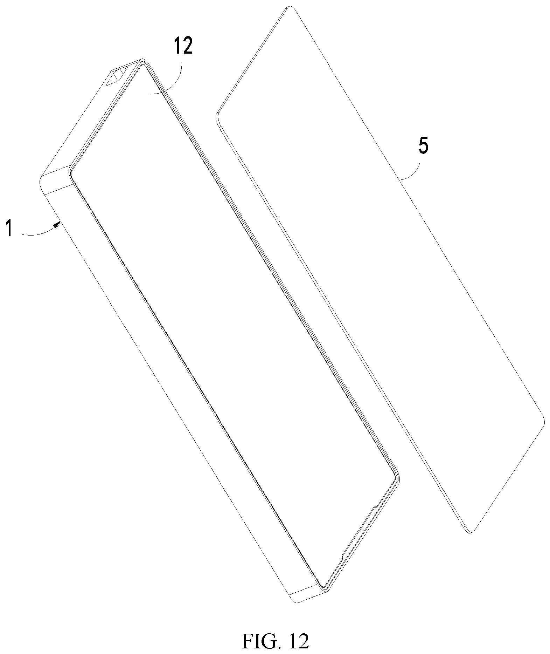

In an embodiment, FIG. 12 is an exploded view of assembling a first body 1 and an anti-slip member 5 in an electronic device mounting apparatus according to an embodiment of this application. Refer to FIG. 12. The mounting apparatus further includes the anti-slip member 5, and the anti-slip member 5 is connected to a surface that is of the first body 1 and that is on a side facing the second body 2. During use of the mounting apparatus, an example in which the mounting apparatus is mounted on the glass is used, the first body 1 may be attached to the surface of the glass through the anti-slip member 5, and a large friction force may be generated between the anti-slip member 5 and the glass. In this way, when the first body 1 and the second body 2 are mutually absorbed on the glass, the first body 1 may be reliably positioned on the glass through the anti-slip member 5, so that the first body 1 can remain fixed or basically fixed on the glass for a long time. "Basically fixed" may be understood as that the first body 1 moves within a small movement range. In other words, the first body 1 has a small movement amount, which may be ignored. For example, the first body 1 rotates within an angle range within 2°, or slides within a range within 1 mm. Such a rotation amount or a sliding amount may be ignored, and it may be considered that the first body 1 is basically fixed. Therefore, the anti-slip member 5 is disposed on the first body 1, so that stability of an absorption position can be ensured after the first body 1 is absorbed on the glass, thereby ensuring stability of mounting the electronic device.

In an embodiment, the anti-slip member 5 may be made of a silicone material, or certainly may be made of another silicon-based material. A material of the anti-slip member 5 is selected to ensure that a fiction force between the anti-slip member 5 and the glass can be increased. This is not limited in embodiments.

In an embodiment, with reference to FIG. 12, the anti-slip member 5 and a first casing 12 of the first body 1 are integrally formed by using a molding process. The anti-slip member 5 and the first casing 12 may be reliably combined and fastened by using a molding process, so that the anti-slip member 5 can be effectively prevented from falling off.

Therefore, the electronic device mounting apparatus provided in the embodiment of this application may be fastened on the glass of the window through magnetic attraction without relying on a pole near a house. Because most houses have glass of windows, the mounting apparatus provided in the embodiment can meet requirements of most users. Certainly, as described above, the mounting apparatus may alternatively be fastened on another support apparatus with a small thickness, and application scenarios are more diversified. In addition, the mounting apparatus is detachably clamped on the two sides of the support apparatus, for example, glass, through magnetic attraction, to facilitate assembly and disassembly operations. Mounting can be completed by the user through manual operations without operations such as drilling holes in a wall or a wooden board by using a dedicated tool. Furthermore, the mounting apparatus does not need to be pasted on the glass by using a double-sided tape, and is not affected either by an ambient temperature through magnetic attraction. Moreover, the user also does not need to apply a pressure, and the first body 1 and the second body 2 can be fastened on the support apparatus, for example, glass, by a magnetic attraction force between the first body 1 and the second body 2. This ensures mounting reliability while facilitating mounting.

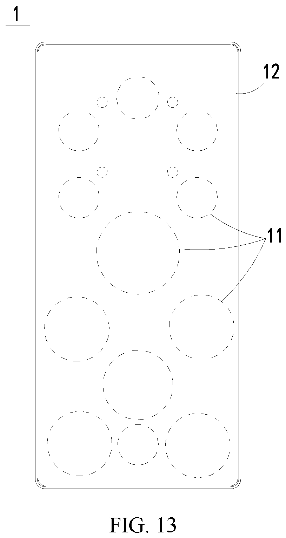

In an embodiment, FIG. 13 is a front view of a first body 1 in an electronic device mounting apparatus according to an embodiment of this application. Refer to FIG. 13. The first body 1 further includes the first casing 12, and the first casing 12 may be wrapped around a surface of the first magnetic member 11. The first casing 12 may be made of plastic, and may be processed and formed by using an injection molding process. The first casing 12 may be completely wrapped around the first magnetic member 11, so that the first magnetic member 11 can be protected, to prevent the first magnetic member 11 from being exposed by sunlight or eroded by rain. This helps prolong an overall service life of the first body 1.

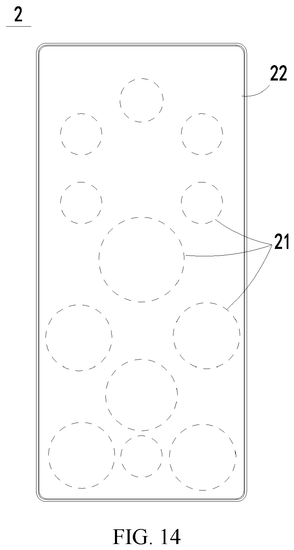

In an embodiment, FIG. 14 is a front view of a second body 2 in an electronic device mounting apparatus according to an embodiment of this application. Refer to FIG. 14. The second body 2 may also include a second casing 22, and the second casing 22 is wrapped around a surface of the second magnetic member 21. The second casing 22 may be made of a material that is the same as or similar to that of the first casing 12. For example, the first casing 12 and the second casing 22 each may be made of ABS plastic. When the first body 1 or the second body 2 is located outdoors, the material of the casing of the first body 1 or the second body 2 that is disposed outdoors may be outdoor PC plastic, to enhance an anti-corrosion capability, an anti-oxidation capability, and the like, and the material of the casing of the first body 1 or the second body 2 that is disposed indoors may be the ABS plastic. Certainly, materials of the first casing 12 and the second casing 22 may alternatively be other materials. This is not limited in embodiments. The second casing 22 may also protect the second magnetic member 21, to prolong an overall service life of the second body 2.

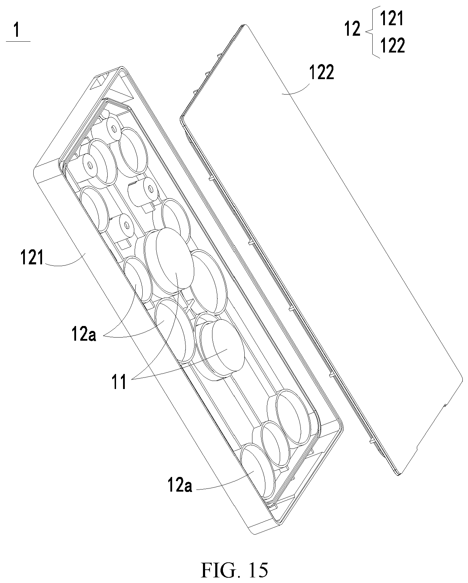

In an embodiment, FIG. 15 is an exploded view of a first body 1 in an electronic device mounting apparatus according to an embodiment of this application. Refer to FIG. 15. The first casing 12 includes a first housing 121 and a first cover body 122. The first cover body 122 is engaged with the first housing 121. After the first housing 121 and the first cover body 122 are engaged with each other, one or more first enclosed spaces may be formed between the first cover body 122 and the first housing 121. The first magnetic member 11 may be disposed in the first enclosed space. The first housing 121 and the first cover body 122 may be separately processed and formed, and the first housing 121 may be engaged with and connected to the first cover body 122 through assembly. For example, the first housing 121 and the first cover body 122 may be fastened through cooperation between a sliding rail and a sliding groove, or may be fastened through a snap fit. Alternatively, a cooperating interface of the first housing 121 and the first cover body 122 may be sealingly connected by using a glue dispensing process, a melting process, or a waterproof structure after the first housing 121 is aligned and engaged with the first cover body 122. The first housing 121 can be reliably fastened to the first cover body 122 in all these connection manners. During assembly, the first magnetic member 11 may be first placed at a specified position of the first housing 121, and then the first cover body 122 may be fastened to and engaged with the first housing 121, to enclose the first magnetic member 11 between the first housing 121 and the first cover body 122, thereby facilitating assembly of the first casing 12 and the first magnetic member 11.

To prevent contaminants such as water vapor from penetrating into the inside of the first housing 121 and the first cover body 122 and eroding the first magnetic member 11, the first housing 121 may be sealingly connected to the first cover body 122. For example, a cooperating position between the first housing 121 and the first cover body 122 may be sealed by using a glue dispensing process. Specifically, an adhesive may be coated on the cooperating interface of the first housing 121 and the first cover body 122, and when the first housing 121 is engaged with the first cover body 122, the adhesive may be squeezed and filled on the cooperating interface of the first housing 121 and the first cover body 122, so that the first housing 121 is sealingly connected to the first cover body 122.

For example, the cooperating position of the first housing 121 and the first cover body 122 may be sealed by using a melting process. For example, a material on the cooperating position of the first housing 121 and/or the first cover body 122 may be melted through high-frequency vibration friction such as an ultrasonic wave, and then the first housing 121 and the first cover body 122 may be aligned, so that the first housing 121 and the first cover body 122 can be integrated through a melted material. After the melted material is cured, the cooperating position of the first housing 121 and the first cover body 122 can be effectively sealed, so that the first housing 121 and the first cover body 122 form an enclosed integrated structure. To avoid damaging, when a material on the first housing 121 and/or the first cover body 122 is melted, a structure design required by the first housing 121 and/or the first cover body 122 and avoid reducing structure parameters such as structural strength and design precision, a redundant design may be disposed at a position that is of the first housing 121 and/or the first cover body 122 and that needs to be melted. The redundant design may be a structure design other than the structure design required by the first housing 121 and/or the first cover body 122. For example, the redundant design may be a protrusion structure for melting, and the protrusion structure may be disposed on the cooperating interface of the first housing 121 and/or the first cover body 122. The protrusion structure may continuously extend on the cooperating interface of the first housing 121 and the first cover body 122, and a cross-sectional shape of the protrusion structure may be a triangle, a trapezoid, or the like. This is not limited in embodiments.

For example, a waterproof structure may be used to seal the cooperating position of the first housing 121 and the first cover body 122. For example, a waterproof rubber strip may be mounted at the cooperating interface of the first housing 121 and the first cover body 122. The waterproof rubber strip may be squeezed by the first housing 121 and the first cover body 122 and elastically deformed, so that the waterproof rubber strip can reliably abut against and be attached to the cooperating interface of the first housing 121 and the first cover body 122, thereby eliminating a gap between the first housing 121 and the first cover body 122, to implement waterproof sealing.

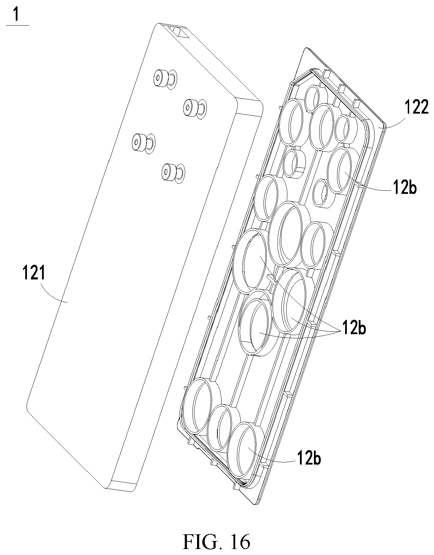

In an embodiment, with reference to FIG. 15, the first housing 121 may be provided with a first positioning groove 12a. FIG. 16 is an exploded view of a first body 1 in an electronic device mounting apparatus according to another embodiment of this application. Refer to FIG. 16. The first cover body 122 may be provided with a first positioning groove 12b. With reference to FIG. 15, quantities, sizes, and position distribution of first positioning grooves 12a in the first housing 121 and first positioning grooves 12b in the first cover body 122 are all the same. After the first cover body 122 is engaged with the first housing 121, the first positioning groove 12a in the first housing 121 and the first positioning groove 12b in the first cover body 122 are aligned in a one-to-one correspondence, and the foregoing first enclosed space can be formed.

In an embodiment, with reference to both FIG. 15 and FIG. 16, a plurality of first positioning grooves 12a in the first housing 121 and a plurality of first positioning grooves 12b in the first cover body 122 may be provided. In this case, there may be a plurality of first enclosed spaces formed by the first positioning grooves 12a in the first housing 121 and the first positioning grooves 12b in the first cover body 122. The first magnetic members 11 may be disposed in all of the first enclosed spaces, or the first magnetic members 11 may be disposed in a part of the first enclosed spaces, and the first magnetic members 11 may be flexibly disposed in the first enclosed spaces at different positions, to meet different mounting scenarios of the electronic device.

The first positioning groove 12a in the first housing 121 may also be sealingly connected to the first positioning groove 12b in the first cover body 122, and a sealed connection manner may be one of the foregoing sealed connection manners between the first housing 121 and the first cover body 122, so that the first enclosed space formed between the first positioning groove 12a in the first housing 121 and the first positioning groove 12b in the first cover body 122 may be a completely sealed space. In this way, the contaminants such as water vapor can be effectively prevented from entering the first enclosed space and eroding the first magnetic member 11.

Only the first housing 121 and the first cover body 122 may be sealingly connected in the foregoing sealing manner, or only the first positioning groove 12a in the first housing 121 and the first positioning groove 12b in the first cover body 122 may be sealingly connected in the foregoing sealing manner. Alternatively, the first housing 121 and the first cover body 122 may be sealingly connected in the foregoing sealing manner, and the first positioning groove 12a in the first housing 121 and the first positioning groove 12b in the first cover body 122 may be sealingly connected in the foregoing sealing manner.

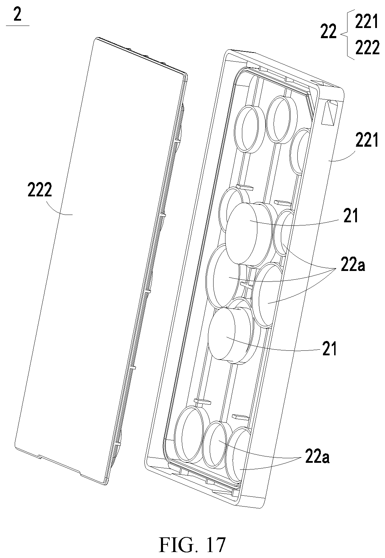

In an embodiment, FIG. 17 is an exploded view of a second body 2 in an electronic device mounting apparatus according to an embodiment of this application. Refer to FIG. 17. The second casing 22 may include a second housing 221 and a second cover body 222. The second cover body 222 is engaged with the second housing 221. A second enclosed space is formed between the second cover body 222 and the second housing 221. The second magnetic member 21 is disposed in the second enclosed space. An assembly manner of the second magnetic member 21, the second cover body 222, and the second housing 221 may be the same as an assembly manner of the first cover body 122, the first housing 121, and the first magnetic member 11, sealing manners are the same, and corresponding technical effects are also similar. Details are not described herein again.

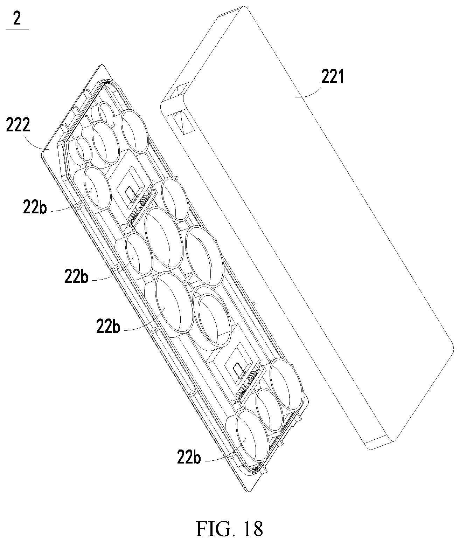

In an embodiment, with reference to FIG. 17, the second housing 221 may be provided with a second positioning groove 22a. FIG. 18 is an exploded view of a second body 2 in an electronic device mounting apparatus according to another embodiment of this application. Refer to FIG. 18. The second cover body 222 may be provided with a second positioning groove 22b. With reference to FIG. 17, quantities, sizes, and position distribution of second positioning grooves 22a in the second housing 221 and second positioning grooves 22b in the second cover body 222 are all the same. After the second cover body 222 is engaged with the second housing 221, the second positioning groove 12a in the second housing 221 and the second positioning groove 12b in the second cover body 222 are aligned in a one-to-one correspondence, and the foregoing second enclosed space can be formed.

In an embodiment, the first casing 12 may be wrapped around the surface of the first magnetic member 11 by using an injection molding process, and/or the second casing 22 may be wrapped around the surface of the second magnetic member 21 by using an injection molding process. The first casing 12 or the second casing 22 formed through injection molding may implement an integrated structure design. This helps improve structural reliability of the first casing 12 and the second casing 22, and can also ensure that a better sealing effect is generated for the first magnetic member 11 or the second magnetic member 21.

When the mounting apparatus is normally used, the first body 1 and the second body 2 are respectively disposed on the two sides of the support apparatus, for example, glass, and the first body 1 and the second body 2 can be clamped on the glass by the magnetic attraction force. However, if a misoperation occurs during use, for example, the first body 1 and the second body 2 are accidentally absorbed, because there is a large magnetic attraction force between the first magnetic member 11 and the second magnetic member 21, it is difficult to separate the first body 1 from the second body 2. Consequently, user experience is degraded. In addition, during use, the large magnetic attraction force between the first magnetic member 11 and the second magnetic member 21 also easily causes pinching of tissues such as fingers or skin of the user by the first body 1 and the second body 2.

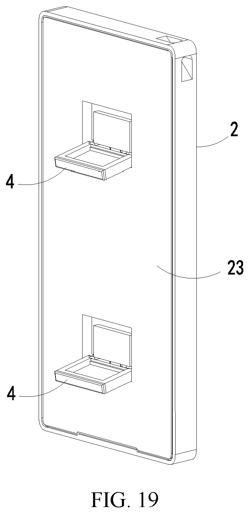

Therefore, in an embodiment, the mounting apparatus may further include a support assembly 4. For example, the support assembly 4 may be connected to the surface that is of the first body and that faces the second body 2. FIG. 19 is a diagram of a structure of a second body 2 in an electronic device mounting apparatus according to another embodiment of this application. Refer to FIG. 19. For example, the support assembly 4 may be connected to a side that is of the second body 2 and that has the second mounting surface 23. For example, a part of the support assembly 4 may be connected to the first body, and the other part of the support assembly 4 may be connected to the second body 2. The support assembly 4 can be switched between a supporting state and a stored state.

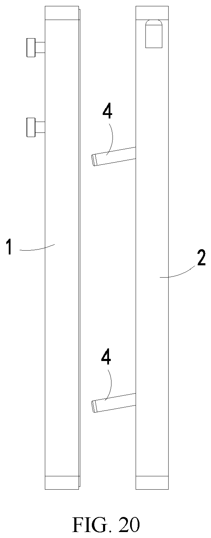

An example in which the support assembly 4 is disposed on the second body 2 is used for description. Refer to FIG. 19. When the second body 2 is in a natural state, that is, not in use, the support assembly 4 is in the supporting state. FIG. 20 is a diagram of cooperation between a first body 1 and a second body 2 when a support assembly in an electronic device mounting apparatus is in a supporting state according to an embodiment of this application. Refer to FIG. 20. When the support assembly 4 is in the supporting state, at least a part of the support assembly 4 protrudes from the surface of the second body 2, and is located between the first body 1 and the second body 2. Through blocking of the support assembly 4, the first body 1 and the second body 2 are not attached to each other, so that the first body 1 and the second body 2 can be prevented from being difficult to separate after being absorbed and attached, or the user can be prevented from being pinched.

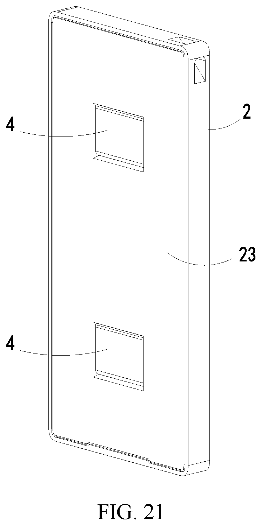

In addition, FIG. 21 is a diagram of a structure of a second body 2 in an electronic device mounting apparatus according to another embodiment of this application. FIG. 21 shows that the support assembly 4 is in the stored state. Refer to FIG. 21. When the support assembly 4 is in the stored state, the support assembly 4 may be stored in the second body 2, and the support assembly 4 does not protrude from the second mounting surface 23 of the second body 2, so that it can be ensured that the second mounting surface 23 can be effectively attached to the support apparatus, for example, glass, when the second body 2 is in use.

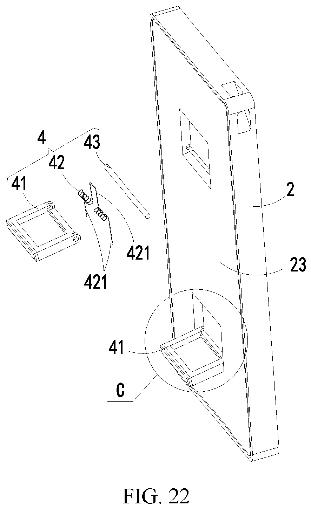

In an embodiment, FIG. 22 is an exploded view of a support assembly 4 in an electronic device mounting apparatus according to an embodiment of this application. Refer to FIG. 22. The support assembly 4 includes a support member 41, an elastic member 42, and a rotating shaft 43, and the support member 41 is rotatably connected to the second body 2 through the rotating shaft 43. One end of the elastic member 42 is connected to the second body 2, and the other end of the elastic member 42 is connected to the support member 41. When the second body 2 is not in use, the support assembly 4 is in the supporting state, and in the supporting state, the elastic member 42 may keep in a compressed state. In this case, an elastic force generated by the elastic member 42 may allow at least a part of the support member 41 to keep in the supporting state, that is, protruding from the surface of the second body 2, and to be located between the first body 1 and the second body 2.

In an embodiment, FIG. 22 shows an example in which the elastic member 42 is a torsion spring. During use, the torsion spring may be sleeved on the rotating shaft 43, and elastic arms 421 at two ends of the torsion spring may abut against the second body 2 and the support member 41 respectively. In some other embodiments, the elastic member 42 may alternatively be a spring plate or the like. This is not limited in embodiments.

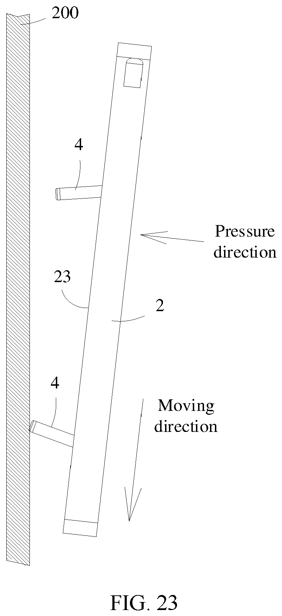

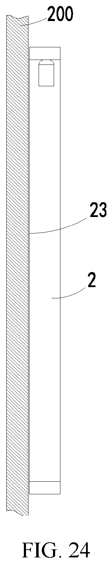

During user, FIG. 23 is a diagram of a process in which a second body 2 in an electronic device mounting apparatus is mounted on glass according to an embodiment of this application. Refer to FIG. 23. An example in which the mounting apparatus is mounted on the glass 200 is used. When the second body 2 is attached to the glass 200, the support member 41 may be first in contact with the glass 200. By applying a specific pressure to the second body 2 (in a pressure direction shown in FIG. 23), and making the second body 2 slightly move in a direction (a moving direction shown in FIG. 23) opposite to a direction in which the support member 41 is ejected from the second body 2, the support member 41 may overcome the elastic force of the elastic member 42 and rotate into the second body 2. FIG. 24 is a diagram showing a state in which a second body 2 in an electronic device mounting apparatus is attached to glass 200 according to an embodiment of this application. Refer to FIG. 24. After the support member 41 rotates into the second body 2, the second mounting surface 23 of the second body 2 can be attached to the glass 200, and the magnetic attraction force between the first magnetic member 11 and the second magnetic member 21 can ensure that the second body 2 is stably clamped on the glass 200. The magnetic attraction force between the first magnetic member 11 and the second magnetic member 21 is greater than an elastic force present when the elastic member 42 is compressed in the stored state.

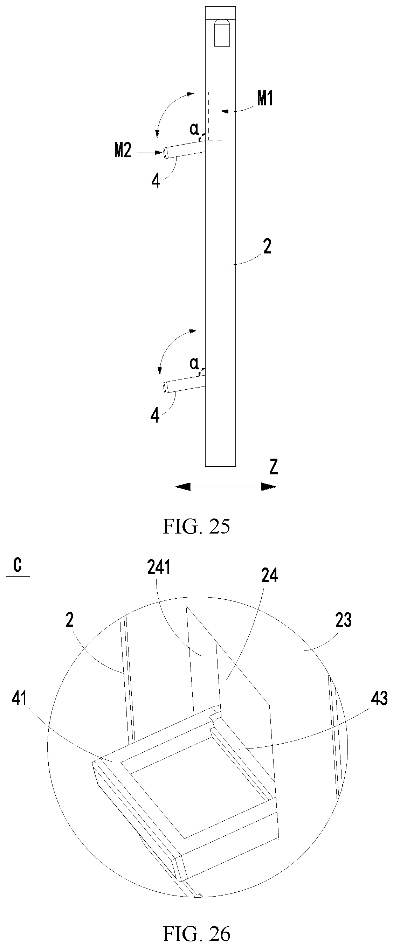

In an embodiment, FIG. 25 is a side view of a second body 2 in an electronic device mounting apparatus according to an embodiment of this application. Refer to FIG. 25. An angle α by which the support member 41 rotates when the stored state is switched to the supporting state is greater than 90°. For ease of description, a position of the support member 41 in the stored state may be defined as a first position, and a position of the support member 41 in the supporting state may be defined as a second position. An angle by which the support member 41 rotates when being switched from the first position to the second position is greater than 90°. In this case, when the support member 41 at the second position is subject to a squeezing force from the first body 1 in a thickness direction Z of the second body 2, the support member 41 may generate a component force in a direction away from the first position, and the component force does not cause the support member 41 to rotate to the first position, so that it can be ensured that the support member 41 can stably function as support.

In an embodiment, FIG. 26 is a partially enlarged diagram at a position C in FIG. 22. Refer to FIG. 26. The second body 2 is provided with a mounting groove 24. The rotating shaft 43 is connected to an inner wall 241 of the mounting groove 24. In the stored state, the support member 41 is stored in the mounting groove 24, and the support member 41 does not protrude from the surface of the second body 2, so that it can be ensured that the second mounting surface 23 of the second body 2 can be effectively attached to the support apparatus, for example, glass.

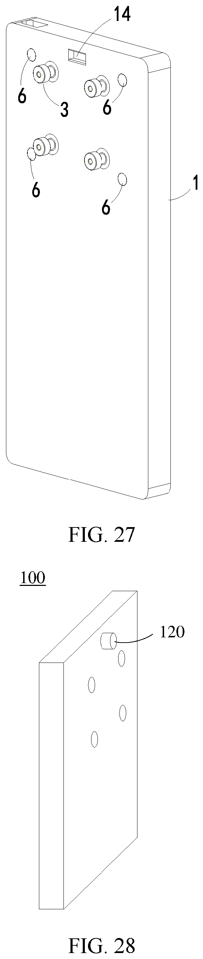

In an embodiment, FIG. 27 is a diagram of a structure of a first body 1 in an electronic device mounting apparatus according to another embodiment of this application. Refer to FIG. 27. The mounting apparatus further includes a buffer member 6. The buffer member 6 is connected to the first body 1, and at least a part of the buffer member 6 protrudes from a surface that is of the first body 1 and that is on a side facing away from the second body 2. In a process in which the electronic device is mounted on the mounting structure 3 of the first body 1, the buffer member 6 may implement buffering through contact with the electronic device, so that the electronic device is prevented from directly colliding with or squeezing the first body 1, and a direct impact force of the electronic device on the first body 1 is reduced. In an embodiment, a material of the buffer member 6 may be silicone, rubber, or the like. Certainly, in some embodiments, the buffer member 6 may alternatively be a spring.

In an embodiment, to facilitate mounting and fastening of the buffer member 6 on the first body 1, the first body 1 may be provided with a groove, and at least a part of the buffer member 6 may be disposed in the groove. The part that is of the buffer member 6 and that is located in the groove may be bonded to an inner wall of the groove by using an adhesive, so that the buffer member 6 can be reliably fastened, and prevented from falling off.

In an embodiment, because the electronic device usually needs to be mounted on a side that is of the first body 1 and that faces away from the second body 2, to achieve a better buffer effect in a process in which the electronic device is mounted on the mounting structure 3, the buffer member 6 and the mounting structure 3 may be both disposed on a side that is of the first body 1 and that faces away from the second body 2. In addition, in some other embodiments, the mounting structure 3 and the buffer member 6 may alternatively be disposed on a top surface, a side surface, or the like of the first body 1. A specific disposition position may be determined based on a mounting requirement of the electronic device. This is not limited in embodiments.

In an embodiment, with reference to FIG. 27, the first body 1 may be further provided with a limiting hole 14. FIG. 28 is a diagram of a structure of an electronic device according to another embodiment of this application. Refer to FIG. 28. The electronic device 100 may be provided with a limiting protrusion 120. With reference to FIG. 27, the limiting hole 14 may cooperate with the limiting protrusion 120 of the electronic device. In a process of mounting the electronic device 100, the limiting protrusion 120 may be inserted into the limiting hole 14 of the first body 1, so that the electronic device 100 can be mounted and limited, and the electronic device 100 can also be prevented from shaking after being mounted, thereby ensuring mounting stability of the electronic device 100.

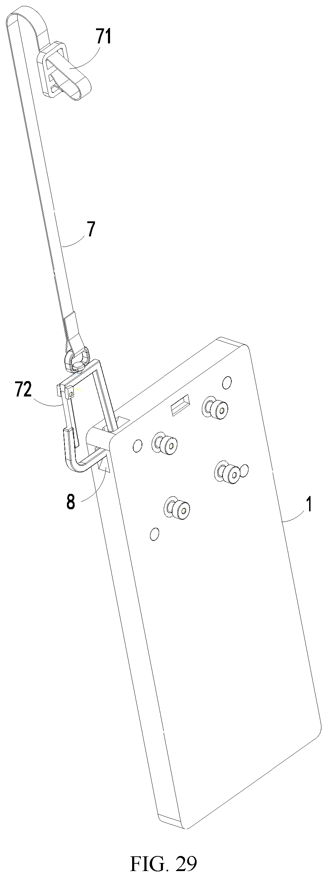

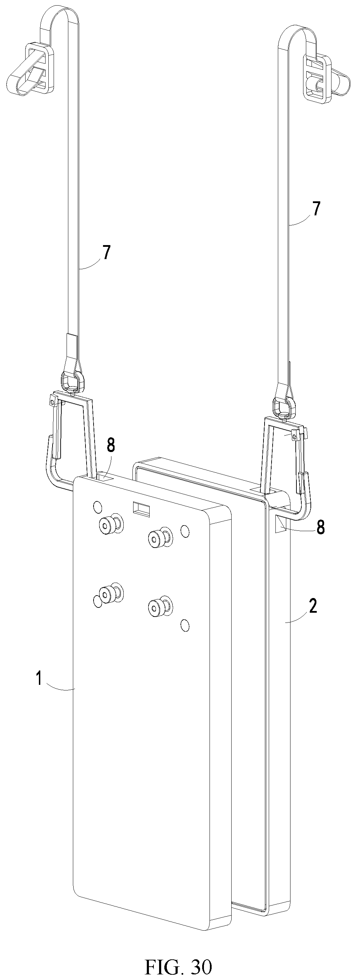

In an embodiment, FIG. 29 is a diagram of cooperation between a first body 1 and a tension member 7 in an electronic device mounting apparatus according to an embodiment of this application. Refer to FIG. 29. The mounting apparatus further includes the tension member 7, and one end of the tension member 7 is connected to the first body 1. Alternatively, in some other embodiments, the tension member 7 may be connected to the second body 2. Alternatively, in some other embodiments, FIG. 30 is a diagram in which a first body 1 and a second body 2 in an electronic device mounting apparatus separately cooperate with a tension member 7 according to an embodiment of this application. Refer to FIG. 30. Two tension members 7 may be disposed, one tension member 7 may be connected to the first body 1, and the other tension member 7 may be connected to the second body 2. The other end of the tension member 7 is a free end 71, and the free end 71 may be connected to a nearby fixed structure. For example, when the first body 1 and the second body 2 are clamped on two sides of the glass of the window, the free end 71 of the tension member 7 may be bound to a handle of the window, or bound to an appropriate structure, for example, a window frame. In this way, when the first body 1 or the second body 2 pulled by the tension member 7 is accidentally detached from the glass, under the action of the tension member 7, the pulled first body 1 or second body 2 can still be prevented from falling off to the ground and being damaged.

In an embodiment, with reference to FIG. 29, the first body 1 may be provided with a mounting hole 8. A latch 72 may be disposed on an end of the tension member 7, and the tension member 7 may be locked onto a side wall of the mounting hole 8 through the latch 72, thereby facilitating assembly of the tension member 7 and the first body 1.

In some other embodiments, with reference to FIG. 30, the second body 2 may also be provided with a mounting hole 8, and the tension member 7 may be connected to the second body 2 through the mounting hole 8 of the second body 2. Details are not described herein again.

The foregoing descriptions are merely preferred embodiments of this application, and are not intended to limit this application. For a person skilled in the art, this application may have various modifications and variations. Any modification, equivalent replacement, or improvement made without departing from the spirit and principle of this application shall fall within the protection scope of this application.

## Claims

1. An electronic device mounting apparatus, comprising:
a first body, wherein the first body comprises a first magnetic member, and a mounting structure for mounting of an electronic device is disposed on the first body;
a second body, wherein the second body comprises a second magnetic member, the second magnetic member is configured to cooperate with the first magnetic member to generate mutually attractive forces, and the second magnetic member and the first magnetic member are respectively absorbed on two sides of a support apparatus by the mutually attractive forces; and
an anti-slip member, wherein the anti-slip member is connected to a surface that is of the first body and that is on a side facing the second body.

2. The electronic device mounting apparatus according to claim 1, wherein the first body further comprises a first casing, and the first casing is wrapped around a surface of the first magnetic member; and/or
the second body further comprises a second casing, and the second casing is wrapped around a surface of the second magnetic member.

3. The electronic device mounting apparatus according to claim 2, wherein the first casing comprises a first housing and a first cover body, the first cover body is engaged with the first housing, a first enclosed space is formed between the first cover body and the first housing, and the first magnetic member is disposed in the first enclosed space; and/or
the second casing comprises a second housing and a second cover body, the second cover body is engaged with the second housing, a second enclosed space is formed between the second cover body and the second housing, and the second magnetic member is disposed in the second enclosed space.

4. The electronic device mounting apparatus according to claim 3, wherein the first housing and the first cover body each are provided with a first positioning groove, and when the first housing and the first cover body are engaged with each other, the first positioning groove of the first housing and the first positioning groove of the first cover body are correspondingly engaged with each other, to form the first enclosed space between the first positioning groove of the first housing and the first positioning groove of the first cover body; and/or
the second housing and the second cover body each are provided with a second positioning groove, and when the second housing and the second cover body are engaged with each other, the second positioning groove of the second housing and the second positioning groove of the second cover body are correspondingly engaged with each other, to form the second enclosed space between the second positioning groove of the second housing and the second positioning groove of the second cover body.

5. The electronic device mounting apparatus according to claim 4, wherein the first housing and the first cover body are sealingly engaged with each other; and/or
the second housing and the second cover body are sealingly engaged with each other; and/or
the first positioning groove of the first housing and the first positioning groove of the first cover body are sealingly engaged with each other; and/or
the second positioning groove of the second housing and the second positioning groove of the second cover body are sealingly engaged with each other.

6. The electronic device mounting apparatus according to claim 5, wherein the first housing and the first cover body are sealingly engaged with each other by using a glue dispensing process, a melting process, or a waterproof structure; and/or
the second housing and the second cover body are sealingly engaged with each other through a glue dispensing process, a melting process, or a waterproof structure; and/or
the first positioning groove of the first housing and the first positioning groove of the first cover body are sealingly engaged with each other by using a glue dispensing process, a melting process, or a waterproof structure; and/or
the second positioning groove of the second housing and the second positioning groove of the second cover body are sealingly engaged with each other by using a glue dispensing process, a melting process, or a waterproof structure.

7. The electronic device mounting apparatus according to claim 2, wherein the first casing is wrapped around the surface of the first magnetic member by using an injection molding process; and/or
the second casing is wrapped around the surface of the second magnetic member through an injection molding process.

8. The electronic device mounting apparatus according to any one of claims 1 to 7, wherein the mounting structure comprises a fastener, one end of the fastener is connected to the first body, and the other end of the fastener protrudes from a surface of the first body for mounting of the electronic device.

9. The electronic device mounting apparatus according to claim 8, wherein the fastener comprises a connection portion and a limiting portion, one end of the connection portion is connected to the first body, and an end that is of the connection portion and that is away from the first body is connected to the limiting portion; and
the limiting portion protrudes from a side surface of the connection portion in a radial direction of the connection portion.

10. The electronic device mounting apparatus according to any one of claims 1 to 9, further comprising a support assembly, wherein the support assembly is connected to the first body and/or the second body, and is switchable between a supporting state and a stored state; and
when the support assembly is in the supporting state, at least a part of the support assembly protrudes from a surface of the first body and/or a surface of the second body.

11. The electronic device mounting apparatus according to claim 10, wherein a position corresponding to the support assembly in the stored state is a first position, a position corresponding to the support assembly in the supporting state is a second position, and an angle between the first position and the second position is greater than 90°; and
when the support assembly is switched from the supporting state to the stored state, the first body and/or the second body on which the support assembly is disposed are/is enabled to move in a direction away from the first position and in a direction close to the support apparatus, and when the first body and/or the second body on which the support assembly is disposed are/is attached to the support apparatus, the support assembly is switched to the stored state.

12. The electronic device mounting apparatus according to claim 10 or 11, wherein the support assembly comprises a support member, an elastic member, and a rotating shaft, and the support member is rotatably connected to the first body and/or the second body through the rotating shaft; and
one end of the elastic member is connected to the first body and/or the second body, the other end of the elastic member is connected to the support member, and in the supporting state, at least a part of the support member protrudes from the surface of the first body and/or the surface of the second body by an elastic force of the elastic member.

13. The electronic device mounting apparatus according to claim 12, wherein the first body and/or the second body are/is provided with a mounting groove, the rotating shaft is connected to an inner wall of the mounting groove, and in the stored state, the support member is stored in the mounting groove.

14. The electronic device mounting apparatus according to any one of claims 1 to 13, wherein the anti-slip member and the first casing of the first body are integrally formed by using a molding process.

15. The electronic device mounting apparatus according to any one of claims 1 to 14, further comprising a buffer member, wherein the buffer member is connected to the first body, and at least a part of the buffer member protrudes from the surface of the first body.

16. The electronic device mounting apparatus according to claim 15, wherein the first body is provided with a groove, and at least a part of the buffer member is disposed in the groove.

17. The electronic device mounting apparatus according to claim 15, wherein the buffer member and the mounting structure are both disposed on a surface that is of the first body and that faces away from the second body.

18. The electronic device mounting apparatus according to any one of claims 1 to 17, further comprising a tension member, wherein one end of the tension member is connected to the first body or the second body.

19. The electronic device mounting apparatus according to claim 18, wherein the first body or the second body is provided with a mounting hole, a latch is disposed on an end of the tension member, and at least a part of the latch passes through the mounting hole and is locked onto a side wall of the mounting hole.

20. The electronic device mounting apparatus according to any one of claims 1 to 19, wherein the first body is provided with a limiting hole, and the limiting hole is configured to cooperate with a limiting protrusion on the electronic device.

21. The electronic device mounting apparatus according to any one of claims 1 to 18, wherein the electronic device comprises a camera, a lamp, or an electronic clock.

22. The electronic device mounting apparatus according to any one of claims 1 to 18, wherein the electronic device comprises a communication device, and the communication device comprises customer premises equipment, a remote radio unit, an interface data unit, or a router.

23. An electronic device, comprising a body and the electronic device mounting apparatus according to any one of claims 1 to 22, wherein the electronic device mounting apparatus is used for mounting of the body.
